# EUROPEAN PATENT SPECIFICATION

(11) **EP 0 504 850 B1**
(45) Date of publication and mention of the grant of the patent: **04.09.1996**
(21) Application number: 92104702.3
(22) Date of filing: 18.03.1992
(51) Int. Cl.: H05K 3/00

(54) **Laser machining method and apparatus therefor**
Laserbearbeitungsverfahren und Laserbearbeitungsvorrichtung
Procédé et dispositif d'usinage à laser

(30) Priority: 18.03.1991 JP 52310/91
(43) Date of publication of application: 23.09.1992
(73) Proprietor: HITACHI, LTD., Chiyoda-ku, Tokyo 100 (JP)
(72) Inventor: Hongo, Mikio, Totsuka-ku, Yokohama-shi (JP); Miyauchi, Tateoki, Yokohama-shi (JP); Maruyama, Shigenobu, Yokohama-shi (JP); Sakamoto, Haruhisa, Yokohama-shi (JP); Mizukoshi, Katsuro, Yokohama-shi (JP)
(74) Representative: Altenburg, Udo, Dipl.-Phys.

(56) References cited:
- GB-A- 2 050 750
- JP-A-53 136 968
- JP-A-53 136 968
- JP-A-60 174 671

## Description

The present invention relates to a method for machining a work by irradiating with a laser beam and a laser processing apparatus for irradiating a laser beam to a work so as to machine said work.

A conventional method for processing a metal film formed on a substrate is known from, for example, Japanese magazine DENSHI ZAIRYO "Processing Technique For Correcting Photomask" March 1978, pages 49 to 53. In this conventional method, the laser beam is transferred via a rectangular slit and an imaging lens to a photomask defective portion as a work to be processed, thereby being focused on this photomask defective portion, so that only this defective portion is removed from the photomask.

Furthermore, instead of this rectangular slit, a liquid crystal is employed in another conventional technique as described in, for instance, Japanese patent application of JP-A-53-136968 and JP-A-60-174671. In case of the former patent application, the liquid crystal is employed as the photomask, and the liquid crystal may be utilized as the photomask by differing transmittance of a predetermined portion in the liquid crystal from that of any portion thereof other than the first-mentioned portion. On the Other hand, the latter patent application discloses that the liquid crystal is used as a stamp forming pattern mask, and a marking operation is carried out by the laser beam.

### SUMMARY OF THE INVENTION

In accordance with the above-described prior art "Processing Technique For Correcting Photomask", the metal thin film fabricated on the transparent substrate is processed and removed by way of the laser beam. However, no care is taken in that the metal film functioning as the work to be processed is formed on a substrate having a threshold value for laser machining (namely, minimum energy value required to perform such a laser processing) smaller than, or equal to that of the metal film and the metal film processing/removing operation is executed without causing damages to the substrate as the under layer when the film thickness of the metal film is not uniform. That is to say, since the laser beam having the uniform power density distribution is projected to the metal film, when the overall metal film is processed/removed under such a condition for processing/removing the portion having the thicker film thickness, any damage happens to occur in the substrate under the metal film portion having the thinner film thickness; and on the other hand, when the overall metal film is processed/removed under such a condition for processing/removing the portion having the thinner film thickness, the insufficient processing/removing operation is carried out at the portion having the thicker film thickness, and therefore the metal film may partially remain. To avoid such conventional problems, such a method may be conceived that the overall metal film is not substantially processed and removed, and the metal film is subdivided based on the film thickness for performing the processing/removing operation. However, there is newly another problem that the positioning operation and the laser output setting operation are required every step of the processing/removing method. More specifically, a difficult positioning operation is required for the overlapping part, and also a limitation is made in the number of film subdivision.

In case of the above-described publication of JP-A-53-136968, the liquid crystal elements are merely employed as the photomasks with respect to the photoresist constructed of two regions whose proper exposure conditions are different from each other. In other words, since transmittance of a predetermined portion of this liquid crystal element is merely different from transmittance of portions thereof other than the first-mentioned portion, and also this liquid crystal element is arranged as a mask exclusively used to a pattern to be exposed, no care is taken in that an arbitrary pattern is formed at proper timing. On the other hand, in case of the latter publication of JP-A-60-174671, although an arbitrary pattern is formed by way of either a segment type liquid crystal element, or a dot type liquid crystal element, and the marking operation is carried out by the laser beam, only binary-coded pattern "1" and "0" are simply formed on the liquid crystal element, namely the binary-coded pattern indicate whether or not the laser beam is passed therethrough, and also such a shading pattern having more than three different sorts of transmittance cannot be formed.

An object of the present invention is to provide both a laser processing method and a laser processing apparatus capable of completely matching (removing) a work by projecting a laser beam to this work at one time, without giving any damage to an under layer of this work, while projecting the laser beam to the work formed on the under layer, the threshold value for laser machining of which is substantially equal to, or smaller than the threshold value for laser machining of the work.

To achieve such object, the present invention provides a method as defined in claim 1 and an apparatus as defined in claim 4.

In accordance with this method, since the laser beams having the power density distributions suitable for the respective portions of the work are projected to the work, which is different from the above-described conventional method for projecting the laser beams having the uniform power density distribution, no damage is produced in the under layer for the work due to the fact that the laser beam having the excessive power density is projected to a certain portion of the work. Furthermore, there is another advantage that the processed work does not partially remain due to the fact that the laser beam having insufficiently low power density is projected to a certain portion of the work, resulting in machining of the work under better conditions.

The step for defining the power density distribution of the laser beam may include: a substep for detecting a thickness distribution of said work within said processing region; and a substep for defining said power density distribution of the laser beam based on said detected thickness distribution.

Furthermore, the step for defining the power density distribution of the laser beam may include: a substep for irradiating illumination light having the same wavelength as that of said laser beam to said work within said processing region; a substep for detecting an intensity distribution of light reflected from said work; and a substep for defining the power density distribution of the laser beam (2) based upon the detected intensity distribution.

The power density distribution setting unit may include: a unit for detecting a thickness distribution of said work within said processing region; and a unit for determining the power density distribution of the laser beam based on said detected thickness distribution.

Then, the power density distribution setting unit may include: a unit for projecting illumination light having the same wavelength as that of said laser beam to said work within said processing region; a unit for detecting an intensity distribution of light reflected from said work; and a unit for determining the power density distribution of said laser beam based upon said detected intensity distribution.

Further, the irradiated shape setting unit may include: a transmission type liquid crystal element arranged in a path of said laser beam; a drive unit for controlling a drive of said transmission type liquid crystal element; and a polarizing beam splitter positioned at a rear side of said transmission type liquid crystal element.

Moreover, the power density distribution setting unit may include: a transmission type liquid crystal element arranged in a path liquid crystal element; and a polarizing beam splitter positioned at a rear side of said transmission type liquid crystal element.

According to a further embodiment of the present invention, a conductor-pattern defect may be corrected by projecting a laser beam to said defect formed on a conductor pattern in an electronic circuit substrate, thereby removing said conductor-pattern defect.

In accordance with still another embodiment of the present invention, a circuit pattern may be cut by projecting a laser beam to a circuit pattern in a semiconductor device, thereby cutting the circuit pattern.

### BRIEF DESCRIPTION OF THE DRAWINGS

Fig. 1 is a schematic diagram for showing an arrangement of a laser machining apparatus according to a preferred embodiment of the present invention;
Fig. 2 is an illustration for explaining an operation of a transmission type liquid crystal element employed in the laser machining apparatus of Fig. 1;
Fig. 3 is a graphic representation for showing a relationship between a voltage applied to the transmission type liquid crystal element shown in Fig. 2 and a laser beam output reflected from a polarizing beam splatter;
Fig. 4 schematically shows a defect example occurring in a wiring (conductor) pattern formed on an electronic circuit substrate, which should be processed by laser light;
Fig. 5 is a cross-sectional view of the defect shown in Fig. 4;
Fig. 6 schematically represents an observed image of the wiring pattern formed on the electronic circuit substrate, as viewed on a monitor;
Fig. 7 schematically represents an image difference between the wiring pattern having the defect and the normal wiring pattern, as viewed on a monitor;
Fig. 8 is a schematic diagram for showing an arrangement of a laser machining apparatus according to another preferred embodiment of the present invention;
Fig. 9 is a plan view of a link portion and a peripheral portion thereof, which are used for redundancy of a semiconductor memory;
Fig. 10 is a sectional view of the link portion and also the peripheral portion thereof;
Fig. 11 is a schematic diagram for showing an arrangement of a laser machining apparatus according to a further preferred embodiment of the present invention; and
Fig. 12 is a schematic diagram for representing an arrangement of a laser machining apparatus according to a still further preferred embodiment of the present invention.

### DESCRIPTION OF THE PREFERRED EMBODIMENTS

Referring now to the accompanying drawings, a description will now be made of a laser machining method and a laser machining apparatus according to the present invention; a method and an apparatus for repairing defects on a conductor pattern; and a method and an apparatus for cutting a circuit pattern.

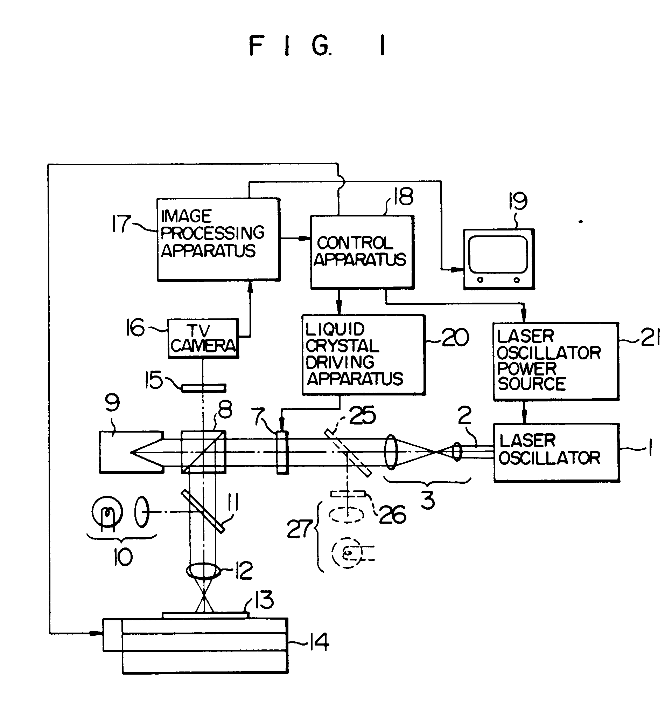

First, a laser machining apparatus according to one preferred embodiment of the present invention will now be described. Fig. 1 represents an arrangement of this laser machining apparatus. In this laser machining apparatus, it is so set that an electronic circuit substrate 13 functioning as a work is machined, by a laser beam 2 emitted from a laser oscillator 1 under such a condition that the electronic circuit substrate 13 is mounted and positioned on an XYZ stage 14 with being sliable along X, Y and Z directions. For the sake of easily explanation, it should be noted the X direction corresponds to left/right directions as viewed in Fig. 1, the Y direction corresponds to a vertical direction with respect to a plane of Fig. 1, and the Z direction corresponds to upper/lower directions.

As shown in Fig. 1, the laser beam 2 emitted from the laser oscillator 1 is incident via a (transmission type) liquid crystal element 7 upon a polarizing beam splitter (cube) 8 under such a state that a beam diameter of this laser beam 2 is expanded by a beam expander 3. In this case, the liquid crystal element 7, a liquid crystal driving apparatus 20 and the polarizing beam splitter 8 are mutually operated so as to function as an irradiated shape setting unit for setting an irradiated shape of the laser beam, and also as a power density distribution setting unit for defining a power density distribution of the laser beam. The laser beam 2 may be polarized in various modes, depending upon voltages applied to a large quantity of matrix-shaped liquid crystal cells which constitute the liquid crystal element 7. In response to the polarizing states, the laser beam 2 passing through the respective liquid crystal cells is directly transmitted through the polarizing beam splitter 8, or is reflected by the polarizing beam splitter 8 along a direction to the electronic circuit board 13. For instance, when the voltage applied to the liquid crystal element 7 is equal to 0, a polarized component of the laser beam 2 from the laser oscillator 1, the polarizing direction of which has been rotated by 90 degrees, is directly transmitted through the polarizing beam splitter 8 and then is absorbed by an absorbing cone 9. On the other hand, when a specific voltage is applied to the liquid crystal element 7, a polarized component of the laser beam 2 from the laser oscillator 1, the polarizing direction of which is identical to the polarizing direction at the polarizing beam splitter 8, is reflected by the polarizing beam splitter 8 toward a direction of the electronic circuit substrate 13. As described above, the laser beam 2 which has been reflected by the polarizing beam splitter 8 and the optical axis of which has been bent at 90 degrees, is transmitted through a dichroic mirror 11 employed so as to combine illuminating light derived from an observation illuminating light source 10. Thereafter, the resultant laser beam 2 is projected onto the electronic circuit substrate 13 under such a condition that the laser beam 2 has been condensed by an objective lens 12. At this time, a pattern on the liquid crystal element 7 is projected on the electronic circuit substrate 13 with a dimension, or size equal to an inverse number of magnification of the objective lens 12. It should be understood that even when the polarizing characteristic of the polarizing beam splitter at the liquid crystal element 7 is opposited to the above-described case, the same technical matters may be applied thereto. In this case, it is of course required to employ such a polarizing beam splitter having a polarizing characteristic opposite to that of the polarizing beam splitter 8.

Prior to the projection of the laser beam 2 toward the electronic circuit substrate 13, on the other hand, an observation image of a surface of the electronic circuit board 13 is imaged or photographed by a television camera 16 via a laser-cut filter 15, an image signal derived from the TV (television) camera 16 is processed by an image processing apparatus 17 and thereafter is transferred to a control apparatus 18 and a monitor 19. In the control apparatus 18, a transmittance distribution has been calculated which is required for obtaining an optimum laser power density distribution to process and remove defects (metal film) formed on a conductor pattern in the electronic circuit substrate 13, based on check results of the conductor pattern (namely, data on a position, a shape, a thickness distribution of a defect in a conductor pattern) inputted into a storage medium such as a floppy disk (not shown). Based upon this calculation result, necessary voltages are applied via the liquid crystal driving apparatus 20 to the respective liquid crystal cells in the liquid crystal element 7. As a consequence, it the laser oscillator 1 is energized by a laser oscillator power source 21 under control of the control apparatus 18 under such conditions that the voltages are being applied to the liquid crystal element 7 and also the laser-cut filter 7 is being inserted in the optical path to the TV camera 16 so as to protect the TV camera from the adverse influence by the laser beam, the laser beam 2 emitted from the laser oscillator 1 is projected via the above-described path toward the electronic circuit substrate 13, whereby the defect formed on the conductor pattern can be processed and removed under such better states.

It should be noted that as represented by a dot line of Fig. 1, if a dichroic mirror 25 is inserted into the path to the laser beam 2 and furthermore an interference filter 26 and a reference light source 27 are provided around this dichroic mirror, a display pattern at the liquid crystal element 7 can be observed. In this case, this dichroic mirror 25 has high reflectivity with respective to a wavelength of the laser beam passing through the interference filter 26, and also high transmittance characteristic with regard to the wavelength of the laser beam 2. A thickness distribution of defects formed on a conductor pattern should be previously recognized when voltages are applied to the liquid crystal element 7. In this regard, various methods for checking the thickness distribution have been proposed. For instance, the thickness distribution of the defects formed on the conductor pattern can be readily checked by way of a method for utilizing an interference fringe of light; a method for utilizing a micro-Moire' fringe; a method for utilizing a scanning tunneling microscope; a method for optically detecting a shift amount of a focal point; a method for utilizing an atomic force microscope (AFM); a method for utilizing a light section method (triangulation method); and also a method for utlizing a cofocal microscope. A step height profiler (surface profiler) may be utilized in a specific case.

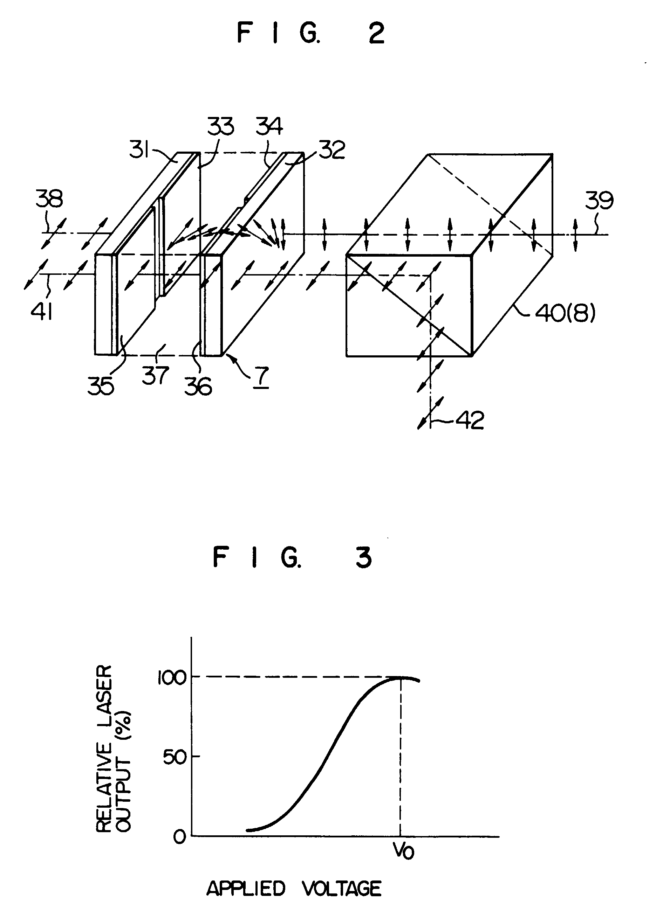

While both the arrangement and the operation of the laser machining apparatus according to one preferred embodiment of the present invention have been summarized, the liquid crystal element 7 that constitutes the most significant constructive element of this laser machining apparatus will now be described more in detail. The liquid crystal element 7 per se is constructed of a large quantity of liquid crystal cells arranged in a matrix form. For instance, this liquid crystal element 7 is arranged by a matrix form of 100 x 100 elements. Here, when an attention is given to two adjoining elements, namely two adjacent liquid crystal cells, as shown in Fig. 2, these liquid crystal cells are so constructed that transparent electrodes 33, 34, 35 and 36 are formed on insides of two glass substrates 31 and 32 positioned opposite to each other, and furthermore a liquid crystal layer (for instance, a twisted nematic liquid crystal layer) 37 is sandwiched between these glass substrates 31 and 32. Assuming now that a laser beam 38 which is externally supplied and has only a polarizing component as indicated by a dot line of Fig. 2, is transmitted through the liquid crystal cell constructed by containing the transparent electrodes 33 and 34 without applying a voltage thereto, after the polarizing direction of the laser beam 38 has been rotated by 90 degrees by the liquid crystal layer 37 within this liquid crystal cell, this laser beam is directly passed through a beam splliter 40 (8) as a laser beam 39 and absorbed by the absorbing cone 9. On the other hand, in case that a proper voltage is applied between the transparent electrodes 35 and 36, and also a laser beam 41 having the same polarizing component as that of laser beam 38 is passed there through, this polarizing component is not rotated within the liquid crystal cell but is reflected at the beam splitter 40, thereby being outputted as a laser beam 42. As a result, when the voltages applied among the transparent electrodes 33, 34, 35 and 36 are varied, as shown in Fig. 3, the output of the laser beam 42 reflected at the beam splitter 40 may be continuously varied from 0% to 100%. On one hand, the laser beam 42 reflected at the beam splitter 40 may be absorbed by the absorbing cone 9, and the laser beam 39 which has passed through the beam splitter 40 may be projected via the objective lens 12 to a work. In case when the laser beam 39 which has passed through the beam splitter 40 is utilized in a laser machining, since a relationship between an applied voltage and an output of transmitting laser beam is reversed with respect to the relationship shown in Fig. 3, the applied voltage may be set in accordance with this relationship.

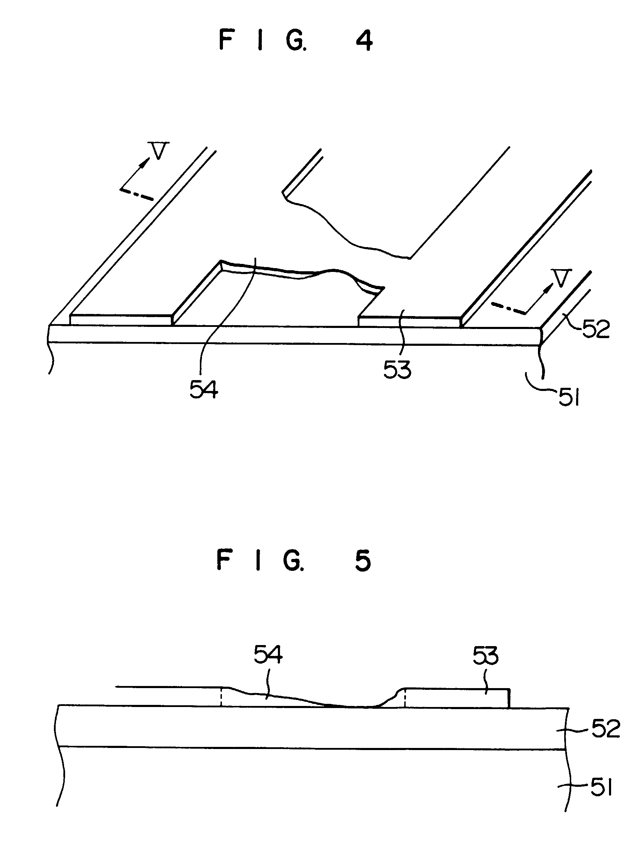

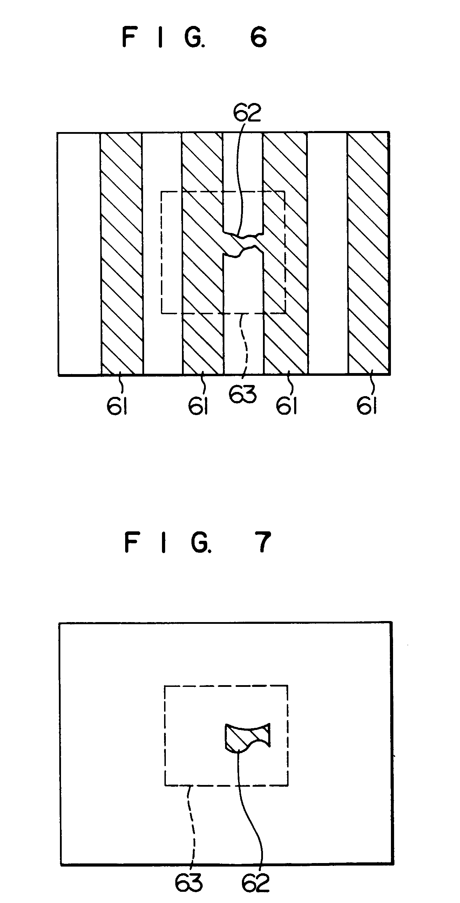

Next, a description will now be made of the electronic circuit board 13 functioning as a work. As partially represented in Fig. 4 as a perspective view, in the latest electronic circuit substrate 13, a metal conductor pattern 53 is formed via an insulating layer 52 such as polyimide on a ceramic substrate 51 such as alumina. As a material of the metal conductor pattern 53, Al, Cu, Mo, W, Cr, NiCr and solder and the like are utilized. Currently, since a width of the metal conductor pattern 53 is very narrowed, the typical width of the conductor pattern is selected to be 20 to 30 µm (microns) and the typical thickness of the conductor pattern is selected to be 5 to 50 µm (microns) Normally, the metal conductor pattern 53 is manufactured by the photoetching process, during which a defect 54 happens to occur in the conductor pattern 53, resulting in lowering a processing yield, as shown in Fig. 4. To increase the manufacturing field, such an amendment to remove the defect 54 formed on the conductor pattern 53 is required and the laser machining operation is the best way for this defect amendment. However, there is a practical problem in case that a thickness of a defect formed on a conductor pattern is not uniform even when the laser machining operation is utilized so as to correct the defect formed on the conductor pattern. Fig. 5 is a cross sectional view of the conductor pattern of Fig. 4, taken along a dot and dash line shown in Fig. 4. As apparent from Fig. 5, since the thicknesses of the defect 54 formed on the conductor pattern 53 are not uniform over its entire surface, if the laser irradiation is carried out whose power density distribution is uniform under such conditions that the thickmost portion of the defect 54 is processed, as in the above-described prior art, a damage may be formed in the polyimide film under the thinner portion of this defect. Conversely, if the laser irradiation is carried out whose power density distribution is uniform under such conditions that the thinner portion of the defect is processed, a portion of the metal present at the thicker portion may remain. In addition to these conventional problems, since a threshold value of laser machining for the insulating layer 52 is smaller than that of the metal conductor pattern 53, in case that the laser irradiation is performed with respect to the insulating layer 52 around the defect portion 54, this insulating layer 52 is readily laser-processed.

Now, the laser machining method according to one preferred embodiment of the present invention will be described more in detail with reference to such an example in which the laser machining operation is carried out by employing the laser machining apparatus as shown in Fig. 1.

In other words, when the electronic circuit substrate 13 is first mounted on an XYZ stage 14, and then the XYZ stage 14 is positionally controlled by the control apparatus based on a coordinate for a position of the defect 54 obtained as the check result of the conductor pattern 53, the position of the defect on the conductor pattern is represented within a field of the TV camera 16 and also the image containing this defect on the conductor pattern is displayed on a monitor 19. In Fig. 6, there is shown such an observation image. As apparent from Fig. 6, both a metal conductor pattern 61 and a defect 62 formed on the conductor pattern can be recognized from the displayed image. A region 63 capable of being machined (namely, a region to which a pattern can be projected from the liquid crystal element 7) is indicated by a dot line on this displayed image, and the XYZ stage 14 is positionally controlled in such a manner that the defect 62 of the conductor pattern should be positioned within the region 63 capable of being machined.

Then, after the observation image signal derived from the TV camera 16 is processed into a binary-coded image pattern by an image processing apparatus 17, a difference pattern is obtained between this binary-coded image pattern and the normal binary-coded image pattern and therefore this difference pattern is represented as an observation image for extracting the defect formed on the conductor pattern on the monitor 19. Fig. 7 shows this observation image for extracting the defect formed on the conductor pattern. From this representation, it may be judged that the partial image 62 corresponds to the region 62 of the defect formed on the conductor pattern. It should be noted that when the liquid crystal element 7 is constructed of, for instance, 100 x 100 pixels, the region 63 capable of being machined is accordingly subdivided into 100 x 100 pixels. In the control apparatus 18, based on the pattern check results, the transmittance of the liquid crystal element is calculated in order to obtain a power density required for removing the results of the conductor pattern, from the thicknesses of the defect films at the respective coordinate (pixel) systems for constituting the partial image 62. In response to the calculation results of the transmittance for the liquid crystal element, a predetermined voltage may be applied to the respective liquid crystal cells for constituting the liquid crystal element 7 from the liquid crystal driving apparatus 20. After the setting operation of the apply voltages for all of the liquid crystal cells has been completed while no voltage is applied to each of the liquid crystal cells corresponding to the portions other than the partial image 62 positioned within the region 63 capable of being processed, the laser oscillator 1 may be energized by the laser oscillator power source 21 under control of the control apparatus 18. Here, the laser oscillator 1 will now be summarized. A pulsed YAG laser, or flash lamp pumped YAG laser (both a fundamental wave and a higher harmonic wave); a glass laser (both a fundamental wave and a higher harmonic wave); and a nitrogen laser pumped dye laser and the like may be employed as this laser oscillator 1, and also a range of an oscillation wavelength is selected from 400 nm to 1,500 nm. A shorter wavelength of the laser wave is absorbed by the liquid crystal, whereas a longer wavelength thereof is absorbed by the glass substrate. After the laser beam 2 emitted from the laser oscillator 1 which is properly selected has been transmitted through the liquid crystal element 7, this laser beam 2 is reflected at the polarizing beam splitter 8 and thereafter is projected only to the defect 54 formed on the conductor pattern in the electronic circuit board 13 via the objective lens 12 with the optimum power density distribution. As a consequence, only the defect 54 formed on the conductor pattern can be machined and removed with better conditions. Since the thicker portion of the metal film can be machined and removed by the laser beam with the higher power density, and the thinner portion thereof can be machined and removed by the laser beam with the lower power density, such a laser processing operation is not carried out up to the insulating layer 52 just under the metal film.

It should be understood that the partial image 62 shown in Fig. 7 is produced from the image imaged by the TV camera 16, and since this partial image 62 is projected onto the electronic circuit substrate 13 via the objective lens 12 after the partial image 62 is transmitted and reflected at the polarizing beam splitter 8, if alignment is previously performed in such a manner that the imaging position by the TV camera 16 is coincident with the projection position from the liquid crystal element 7, the positioning operation after this alignment is no longer required. This is because the partial image 62 is always obtained from the images which have been photographed by the TV camera 16, and the voltage can be applied to the corresponding position of the partial image 62 of the liquid crystal element 7. Also, edge precision of a projection pattern is determined based on the number of pixels constituting the liquid crystal element 7, and the edge precision may be improved by employing such a liquid crystal element having more large pixels, for instance, 256 x 256 pixels than those of the above-described liquid crystal element 7. However, even when a liquid crystal element constituted by 100 x 100 pixels is employed as the above-described liquid crystal element 7, if an objective lens having magnification of 40 is employed and the region 63 capable of being machined is selected to be 100 µm (microns) x 100 µm (microns), a dimension (size) of a projection region per 1 pixel becomes 1 micron and thus the laser beam bulging out from the metal film may be suppressed less than, or equal to 1 µm (micron). Such a small bulging beam never causes a damage to the metal layer around the metal film, and also the metal film can be processed and removed by the laser beam under better state.

Fig. 11 represents an arrangement of a laser machining apparatus according to another preferred embodiment of the present invention. Same reference numerals will be employed in Fig. 11 as those for denoting the same or similar constructive elements shown in Fig. 1, and explanations thereof are omitted.

A different point of this preferred embodiment, as compared with that of Fig. 1, is such that a unit for detecting a thickness distribution of a defect formed on a conductor pattern is additionally employed. In this preferred embodiment, this detecting unit is constructed of elements denoted by reference numerals 81 to 86 shown in Fig. 11, and also arranged by employing cofocal microscope. As represented in Fig. 11, an XYZ stage 14' is made bulky, as compared with the above-described XYZ stage 14 shown in Fig. 1. A light beam emitted from a light source 81 is utilized as a point light source by way of a pin hole 82a formed on a light shield plate 82. This light beam is passed through a half mirror 83 and collected on a product (the electronic circuit substrate 13 in this example) to be checked by an objective lens 84. The light beam reflected from the defect 54 formed on the conductor pattern in the electronic circuit substrate 13, is transmitted through the objective lens 84, and then is reflected at the half mirror 83, and thereafter is passed through the pin hole 85a formed on the light shield plate 85, and inputted into a light detector 86. At this time, it is so designed that one distance from the objective lens 84 to one pin hole 82a is equal to the other distance from the objective lens 84 to the other pin hole 85a. As a consequence, when the point light source is projected onto a surface of a work to be checked, namely a position on which a focal point is made by the objective lens 84 is coincident with the surface of the work to be checked, an amount of the light incident upon the light detector 86 becomes maximum. Under such circumstances, when the work to be checked is scanned by the XYZ stage 14' along the X-Y direction, only the portion of this work positioned at the focal point is detectable by the light detector 86. This operation is repeated while moving this work along the Z direction in a stepwise mode (for instance, 1 µm pitch), so that information about the region to be checked, namely the film thickness distribution may be grasped. It should be noted that although the operation of the control apparatus 18' is in principle the same as that of the control apparatus 18 shown in Fig. 1, this control apparatus 18' owns such an additional function that the output signal derived from the light detector 86 is processed thereby to obtain the thickness distribution of the defect formed on the conductor pattern.

In accordance with the preferred embodiment shown in Fig. 11, since the above explained thickness distribution may be also detected, both the conductor pattern checking operation as well as the correcting operation for the defects on the conductor pattern may be completely automated. It should be noted that the information about the positions and shapes of the defects formed on the conductor pattern is obtained from the image processing apparatus 17.

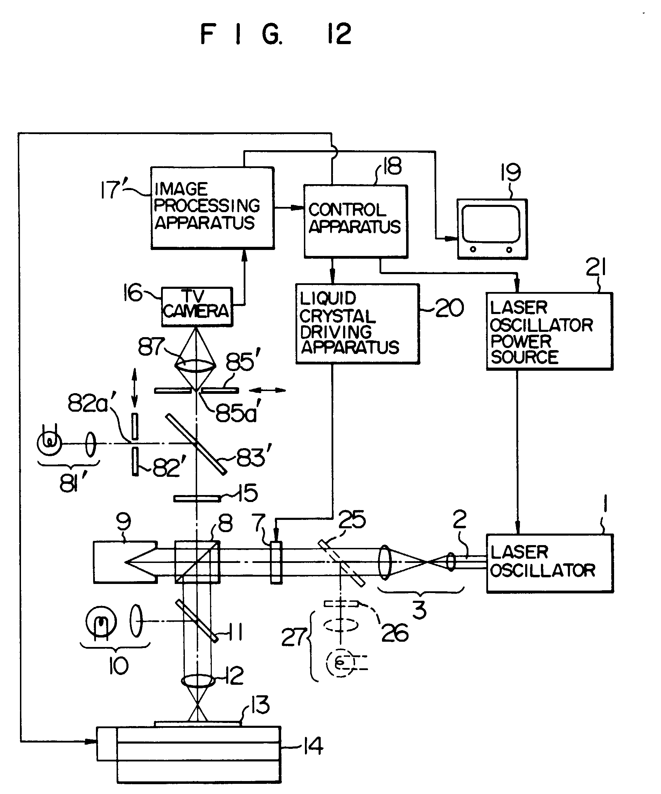

Fig. 12 represents an arrangement of a laser machining apparatus according to a still further preferred embodiment of the present invention. It should be noted that the same reference numerals shown in Fig. 1 will be employed as those for denoting the same or similar constructive elements and explanations thereof are omitted.

In accordance with this preferred embodiment, a unit for detecting a thickness distribution of a defect formed on a conductor pattern is additionally employed similar to that of the preferred embodiment shown in Fig. 11, and then a principle idea to detect such a thickness distribution of the first-mentioned detecting unit is similar to that of the second-mentioned detecting unit shown in Fig. 11. It should be noted that a light source 81' corresponds to the light source 81 shown in Fig. 11; a light shield plate 82' having a pin hole 82a' corresponds to the light source 82 having the pin hole 82a indicated in Fig. 11; a half mirror 83' corresponds to the half mirror 83 of Fig. 11; and also a light shield plate 85' having a pin hole 85a' corresponds to the light shield plate 85 having the pin hole 85a represented in Fig. 11. The function of the objective lens 84 shown in Fig. 11 is achieved by an objective lens 12 shown in Fig. 12. Further, reference numeral 87 of Fig. 12 imaging an image of the pin hole 85a' onto the TV camera 16. The function of the light detector 86 shown in Fig. 12 is achieved by the TV camera 16 shown in Fig. 12. The above-described light shield plates 82' and 85' are movable in synchronism with an operation of a mechanism (not shown) along an arrow direction of Fig. 12. The light shield plate 85' is saved or excluded from the optical path unless the thickness distribution of the defects made on the conductor pattern is detected. In this preferred embodiment shown in Fig. 12, the light shield plate 85' is successively moved by the stage 14 along the Z direction, and the pin hole 82a' is synchronized with the pin hole 85a', which are scanned in the XY directions, so that each pixel of the defect part can be inputted as a brightness value by the TV camera 16. That is to say, when the pin holes 82a' and 85a' are scanned in the XY directions at a certain Z position, only portions coincident with the focal point of the objective lens are lightened at higher intensity due to the above-described positional relationship, and these lighten portions are positioned at the same height (namely, portions having the same film thickness). When the above-described pin-hole XY scanning operation is carried out along the Z direction, heights of the respective scanned portions can be detected, which may be converted into the luminance distribution in the image processing apparatus 17', depending on the position along the Z direction.

Also in the preferred embodiment shown in Fig. 12, since the thickness distribution may be detected, both the conductor pattern checking operation and the correcting operation for the defects made on the conductor pattern can be completely automated.

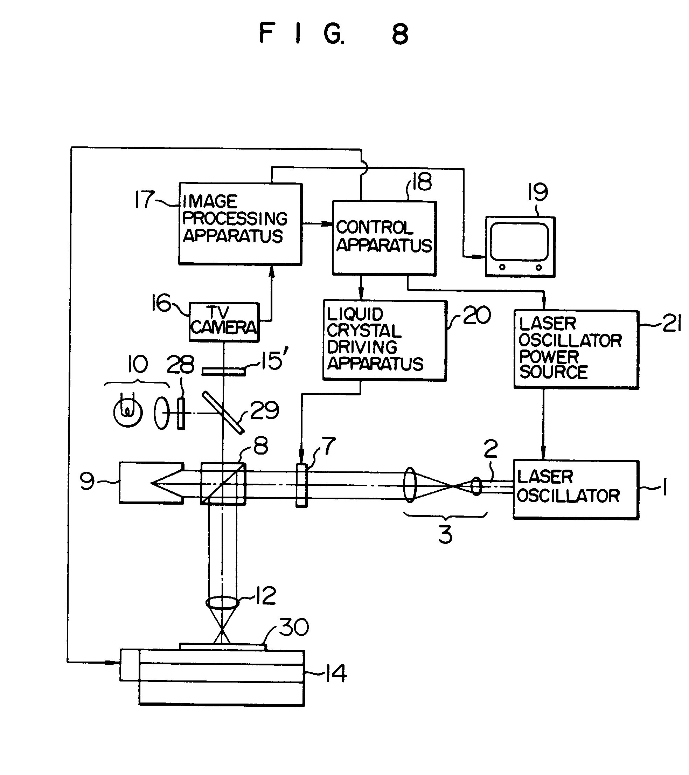

In Fig. 8, there is shown a construction of a laser machining apparatus according to a further preferred embodiment of the present invention. It should be noted that the same reference numerals shown in Fig. 1 will be employed as those for denoting the same or similar constructive elements shown in Fig. 8, and explanations thereof are omitted. An essential difference between the arrangement of the laser machining apparatus shown in Fig. 1 and that of Fig. 8 is that a semiconductor wafer 30 is illuminated by illumination light having the same wavelength as that of the laser beam 2 emitted from the laser oscillator 1. In other words, after only the illumination light having the same wavelength as that of the laser beam 2 is derived by the interference filter 28 from the illumination light emitted from the observation light source 10, this derived illumination light is reflected by the half mirror 29, whereby the semiconductor wafer 30 as a work is illuminated. Under such illuminating state, an image of this semiconductor wafer 30 is imaged by the TV camera 16. The image signal derived from the TV camera 16 is processed by the image processing apparatus 17. In the control apparatus 18, a relative absorption factor and furthermore a power density of a laser beam to be illuminated and also transmittance of the liquid crystal element 7 are calculated from the brightness of the link portion (link portion as an actual work will be described later). Based on the calculation result of the transmittance for the liquid crystal element, a predetermined voltage is applied to each cell of the liquid crystal element 7 from the liquid crystal driving apparatus 20. When the laser oscillator 1 is energized by the laser oscillator power source 21 under control of the control apparatus 18 with such conditions that the voltages are applied to the respective liquid crystal cells and furthermore a shutter 5 is closed in order to protect the TV camera 16 from the laser beam, the laser beam 2 emitted from the laser oscillator 1 is projected via the above-described optical path to the semiconductor wafer 30 and thus the link portion can be machined and removed by the laser machining apparatus under better conditions.

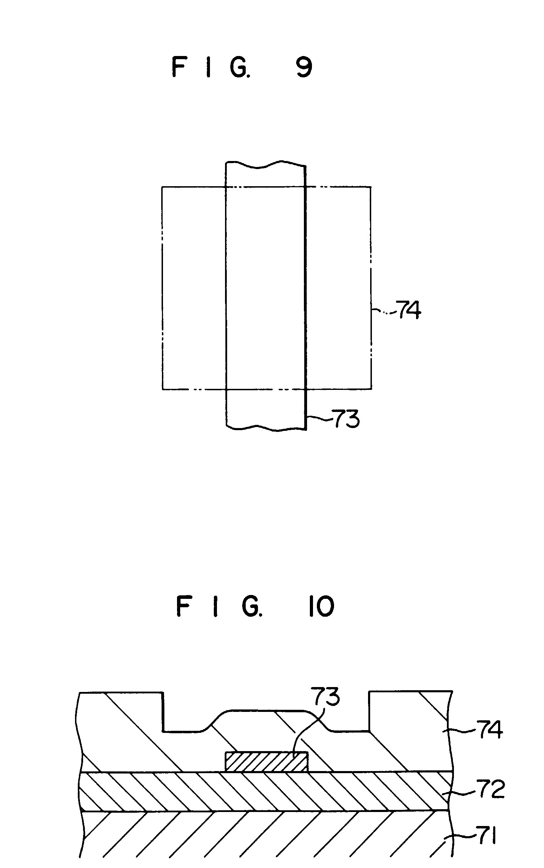

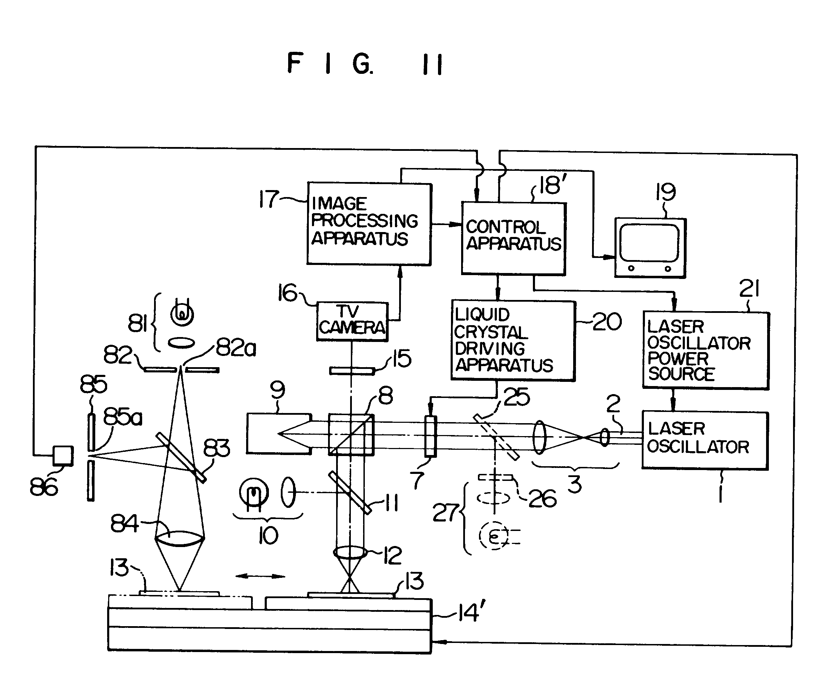

A supplemental explanation will now be made of a method for laser-processing a link portion as a work to be processed by the laser machining apparatus shown in Fig. 8. Fig. 9 illustrates a link portion for redundancy of a semiconductor, functioning as a work to be processed (namely, a conductor portion used for changing a defective memory cell into a spare memory cell by being cut by a laser beam), and also a plane around this link portion. Fig. 10 is a cross-sectional view of this link portion and the peripheral portion thereof. As represented in these figures, a poly-silicon line (link portion) 73 is furthermore formed on a theremal oxide film (SiO₂ film) fabricated on a Si substrate 71, and the poly-silicon line 73 is protected by an insulating film 74 formed thereof. In this case, the insulating film 74 is made of an interlayer insulator film and also a final passivation film. Normally, although this insulating film 74 is manufactured by either a SiO₂ film and/or a SiN film, the insulating film just above the link portion 73 has such a thinner film thickness which can be readily laser-processed. However, in case that the laser beam is illuminated to the link portion 73 so as to change the defective memory cell into the spare memory cell, the laser beam may cause interference due to the film thicknesses of the insulating film 74 formed on the link portion 73, and thus power of the laser beam which can reach the link portion 73 is greatly varied. As a result, even when the laser processing operation is carried out under the same condition, there are such problems that the link portion 73 cannot be cut and damages happen to occur in the Si substrate 71.

Thus, according to this preferred embodiment, the observation image of the link portion 73 to be laser-processed is acquired by the TV camera 16 under such an illumination light having the same wavelength as that of the laser beam 2, and then processed by the image processing apparatus 17. Thereafter, an image of this link portion is extracted and then the brightness distribution at the link portion 73 is evaluated. Since the relative absorption factor and the optimum power density required to carry out the laser machining operation can be calculated from the intensity distribution of the reflection light, the transmittance of the respective liquid crystal cells for constituting the liquid crystal element 7 can be obtained. After the voltages required for the respective liquid crystal cells are applied to these cells corresponding to the extracted link image based on this transmittance, the laser oscillator 1 may be energized. As a result, the link portion 73 can be processed and removed under the better conditions. For example, a length of the link portion 73 to be processed and removed is set to be equal to a value obtained by multiplying a width of this link portion by 2 to 5. Normally, transmittance for each of the liquid crystal cells corresponding to the link portion 73 may be selected to be identical to each other. If required, the transmittance for the central part of the link portion 73 may be varied with respect to that for the peripheral part thereof. As a consequence, even if the film thickness of the insulating film 74 above the link portion 73 is not uniform and also reflectance is slightly varied due to interference, the laser beam having a constant power density is continuously absorbed by the link portion 73, so that neither a damage is produced on the Si substrate, nor the link portion 73 remains without being processed and cut away therefrom.

As previously explained in detail, in case that the work formed on the under layer, the threshold value for laser machining of which is substantially equal to, or lower than that of the under layer, is machined and removed by the laser beam, this work can be completely processed and removed by irradiating once the laser beam thereto without giving any damage to the under layer.

## Claims

1. Method for machining a work (13) by irradiating with a laser beam (2) comprising the steps of
defining the shape of an area (62) to be machined in a region (63) of the work (13) and acquiring corresponding image signals;
using the image signals to shape the irradiation area (62) of the laser beam (2) according to the shape of the area (62) to be machined, and
controlling the distribution of power density in the irradiation area of the laser beam to remove predetermined amounts of material (54) from the machined work.

2. A method as claimed in claim 1, wherein the step for controlling the distribution of power density includes a substep for detecting a thickness distribution of the predetermined material of the area to be machined, and a substep for defining the power density distribution of the laser beam according to the thickness distribution thus detected.

3. A method as claimed in claim 1, wherein the step for controlling said power density distribution includes a substep for irradiating an illumination light, having a same wavelength as that of the laser beam, to the work, a substep for detecting the intensity distribution of said illumination light reflected on the work, and a substep for defining the power density distribution of the laser beam according to the thickness distribution thus detected.

4. A laser processing apparatus for irradiating a laser beam (2) to a work (13) so as to machine said work (13), comprising:
means (16) for obtaining an image of a region (63) which includes an area (62) to be machined on said work (13),
means (17) for defining the shape of the area (62) to be machined from the image;
means (18) for defining the shape of the irradiation area of said laser beam according to the defined shape of the area to be machined;
means for controlling the power density distribution of the laser beam (2) to be adequate to remove a predetermined material (54) of the area to be machined from said work (13).

5. A laser processing apparatus as claimed in claim 4, wherein the means for controlling the power density distribution includes means for detecting the thickness distribution of the predetermined material of the area to be machined, and means for defining the power density distribution of the laser beam according to the thickness distribution thus detected.

6. A laser processing apparatus as claimed in claim 4, wherein the means for controlling the power density distribution includes means for irradiating an illumination light having the same wavelength as that of the laser beam to the work, means for detecting the intensity distribution of the illumination light reflected on the work, and means for defining the power density distribution of the laser beam according to the thickness distribution thus detected.

7. A laser processing apparatus as claimed in claim 4, wherein the means for defining the shape of the irradiation area of the laser beam includes a transmission type liquid crystal element (7) arranged in the path of the laser beam (2), means (20) for driving the transmission type liquid crystal element (7), and a polarizing beam splitter (8) positioned at the rear side of the transmission type liquid crystal element (7).

8. A laser processing apparatus as claimed in claim 4, wherein the means for controlling the power density distribution includes a transmission type liquid crystal element (7) arranged in the path of the laser beam (2), means (20) for driving the transmission type liquid crystal element (7), and a polarizing beam splitter (8) positioned at the rear side of the transmission type liquid crystal element (7).

## Patentansprüche

1. Verfahren zum maschinellen Bearbeiten eines Werkstückes (13) durch Bestrahlen mit einem Laserstrahl (2), das die Schritte aufweist:
Definieren der Form eines Bereiches (62), der maschinell bearbeitet werden soll, in einem Gebiet (63) des Werkstückes (13) und Erlangen entsprechender Bildsignale;
Verwenden der Bildsignale, um den Bestrahlungsbereich (62) des Laserstrahles (2) gemäß der Form des Bereiches (62), der maschinell bearbeitet werden soll, zu formen, und
Steuern der Verteilung der Energiedichte in dem Bestrahlungsbereich des Laserstrahles, um vorbestimmte Mengen von Material (54) von dem maschinell bearbeiteten Werkstück zu entfernen.

2. Verfahren gemäß Anspruch 1, wobei der Schritt des Steuerns der Verteilung der Energiedichte einen Unterschritt zum Erfassen einer Dickeverteilung des vorbestimmten Materials des maschinell zu bearbeitenden Bereiches und einen Unterschritt zum Definieren der Energiedichteverteilung des Laserstrahles gemäß der so erfaßten Dickeverteilung aufweist.

3. Verfahren gemäß Anspruch 1, wobei der Schritt des Steuerns der Energiedichteverteilung einen Unterschritt zum Bestrahlen des Werkstücks mit einem Beleuchtungslicht, das die gleiche Wellenlänge wie die des Laserstrahles hat, einen Unterschritt zum Erfassen der Intensitätsverteilung des Beleuchtungslichtes, das auf dem Werkstück reflektiert wird, und einen Unterschritt zum Definieren der Energiedichteverteilung des Laserstrahles gemäß der so erfaßten Dickeverteilung aufweist.

4. Laserbearbeitungsgerät zum Bestrahlen eines Werkstückes (13) mit einem Laserstrahl (2), um das Werkstück (13) maschinell zu bearbeiten, das aufweist:
eine Einrichtung (16) zum Erhalten eines Bildes eines Gebietes (63), das einen Bereich (62) aufweist, der auf dem Werkstück (13) maschinell bearbeitet werden soll,
eine Einrichtung (17) zum Definieren der Form des Bereiches (62), der maschinell bearbeitet werden soll, aus dem Bild;
eine Einrichtung (18) zum Definieren der Form des Bestrahlungsbereiches des Laserstrahles gemäß der definierten Form des Bereiches, der maschinell bearbeitet werden soll;
eine Einrichtung zum Steuern der Energiedichteverteilung des Laserstrahles (2), so daß sie adäquat ist, um ein vorbestimmtes Material (54) des Bereiches, der maschinell bearbeitet werden soll, von dem Werkstück (13) zu entfernen.

5. Laserbearbeitungsgerät gemäß Anspruch 4, wobei die Einrichtung zum Steuern der Energiedichteverteilung eine Einrichtung zum Erfassen der Dickeverteilung des vorbestimmten Materials des Bereiches, der maschinell bearbeitet werden soll, aufweist, und eine Einrichtung zum Definieren der Energiedichteverteilung des Laserstrahles gemäß der so erfaßten Dickeverteilung.

6. Laserbearbeitungsgerät gemäß Anspruch 4, wobei die Einrichtung zum Steuern der Energiedichteverteilung eine Einrichtung zum Bestrahlen des Werkstückes mit einem Beleuchtungslicht, das die gleiche Wellenlänge wie die des Laserstrahles hat, eine Einrichtung zum Erfassen der Intensitätsverteilung des Beleuchtungslichtes, das auf dem Werkstück reflektiert wird, und eine Einrichtung zum Definieren der Energiedichteverteilung des Laserstrahles gemäß der so erfaßten Dickeverteilung aufweist.

7. Laserbearbeitungsgerät gemäß Anspruch 4, wobei die Einrichtung zum Definieren der Form des Bestrahlungsbereiches des Laserstrahles ein Flüssigkristallelement (7) vom Transmissionstyp, das in dem Weg des Laserstrahles (2) angeordnet ist, eine Einrichtung (20) zum Antreiben des Flüssigkristallelementes (7) vom Transmissionstyp und einen polarisierenden Strahlaufteiler (8) aufweist, der an der hinteren Seite des Flüssigkristallelementes (7) vom Transmissionstyp positioniert ist.

8. Laserbearbeitungsgerät gemäß Anspruch 4, wobei die Einrichtung zum Steuern der Energiedichteverteilung ein Flüssigkristallelement (7) vom Transmissionstyp, das in dem Weg des Laserstrahles (2) angeordnet ist, eine Einrichtung (20) zum Antreiben des Flüssigkristallelementes (7) vom Transmissionstyp und einen polarisierenden Strahlaufteiler (8) aufweist, der an der hinteren Seite des Flüssigkristallelementes (7) vom Transmissionstyp positioniert ist.

## Revendications

1. Procédé pour usiner une pièce (13) par irradiation par un faisceau laser (2), comportant les étapes consistant à :
définir la forme d'une surface (62) à usiner dans une région (63) de la pièce et acquérir des signaux d'image correspondants;
utiliser les signaux d'image pour mettre en forme la surface d'irradiation (62) du faisceau laser (2) en fonction de la forme de la surface (62) à usiner, et
commander la distribution de densité de puissance dans la surface d'irradiation du faisceau laser de façon à retirer des quantités prédéterminées de matériau (54) de la pièce usinée.

2. Procédé selon la revendication 1, dans lequel l'étape pour commander la distribution de densité de puissance comprend une sous-étape pour détecter une distribution d'épaisseur du matériau prédéterminé de la surface à usiner, et une sous-étape pour définir la distribution de densité de puissance du faisceau laser en fonction de la distribution d'épaisseur ainsi détectée.

3. Procédé selon la revendication 1, dans lequel l'étape pour commander ladite distribution de densité de puissance comprend une sous-étape pour irradier une lumière d'illumination, ayant la même longueur d'onde que celle du faisceau laser, sur la pièce, une sous-étape pour détecter la distribution d'intensité de ladite lumière d'illumination réfléchie sur la pièce, et une sous-étape pour définir la distribution de densité de puissance du faisceau de laser en fonction de la distribution d'épaisseur ainsi détectée.

4. Dispositif de traitement par laser pour irradier un faisceau de laser (2) sur une pièce (13) de façon à usiner ladite pièce (13), comprenant:
des moyens (16) pour obtenir une image d'une région (63) qui comprend une surface (62) à usiner sur ladite pièce (13) ; des moyens (17) pour définir la forme de la surface (62) à usiner à partir de l'image ;
des moyens (18) pour définir la forme de la surface d'irradiation dudit faisceau laser en fonction de la forme définie de la surface à usiner;
des moyens pour commander la distribution de densité de puissance du faisceau laser (2) de telle sorte qu'elle soit adéquate pour retirer un matériau prédéterminé (54) de la surface à usiner de ladite pièce (13).

5. Dispositif de traitement par laser selon la revendication 4, dans lequel les moyens pour commander la distribution de densité de puissance comprennent des moyens pour détecter la distribution d'épaisseur du matériau prédéterminé de la surface à usiner, et des moyens pour définir la distribution de densité de puissance du faisceau laser en fonction de la distribution d'épaisseur ainsi détectée.

6. Dispositif de traitement par laser selon la revendication 4, dans lequel les moyens pour commander la distribution de densité de puissance comprennent des moyens pour irradier une lumière d'illumination ayant la même longueur d'onde que celle du faisceau laser sur la pièce, des moyens pour détecter la distribution d'intensité de la lumière d'illumination réfléchie sur la pièce, et des moyens pour définir la distribution de densité de puissance du faisceau laser en fonction de la distribution d'épaisseur ainsi détectée.

7. Dispositif de traitement par laser selon la revendication 4, dans lequel les moyens pour définir la forme de la surface d'irradiation du faisceau laser comprennent un élément à cristaux liquides du type à transmission (7) disposé dans le chemin du faisceau laser (2), des moyens (20) pour commander l'élément à cristaux liquides du type à transmission (7), et un diviseur de faisceau à polarisation (8) positionné du côté arrière de l'élément à cristaux liquides du type à transmission (7).

8. Dispositif de traitement par laser selon la revendication 4, dans lequel les moyens pour commander la distribution de densité de puissance comprennent un élément à cristaux liquides du type à transmission (7) disposé dans le chemin du faisceau de laser (2), des moyens (20) pour commander l'élément à cristaux liquides du type à transmission (7), et un diviseur de faisceau de polarisation (8) positionné du côté arrière de l'élément à cristaux liquides du type à transmission (7).
